Europäisches Patentamt

European Patent Office

Office européen des brevets

(11) Veröffentlichungsnummer: **0 302 550**
**A2**

## EUROPÄISCHE PATENTANMELDUNG

(21) Anmeldenummer: 88201576.1

(51) Int. Cl.⁴: **G01N 24/08**

(22) Anmeldetag: 20.07.88

(30) Priorität: 04.08.87 DE 3725800

(43) Veröffentlichungstag der Anmeldung:
**08.02.89 Patentblatt 89/06**

(84) Benannte Vertragsstaaten:
**DE FR GB NL**

(71) Anmelder: **Philips Patentverwaltung GmbH
Wendenstrasse 35 Postfach 10 51 49
D-2000 Hamburg 1(DE)**

(84) **DE**

(71) Anmelder: **N.V. Philips' Gloeilampenfabrieken
Groenewoudseweg 1
NL-5621 BA Eindhoven(NL)**

(84) **FR GB NL**

(72) Erfinder: **McKinnon, Graeme Colin, Dr.
Höschgasse 62
CH-8008 Zürich(CH)**
Erfinder: **Bösiger, Peter, Dr.
Rebbergstrasse 73
CH-5400 Ennetbaden(CH)**

(74) Vertreter: **Hartmann, Heinrich, Dipl.-Ing. et al
Philips Patentverwaltung GmbH
Wendenstrasse 35 Postfach 10 51 49
D-2000 Hamburg 1(DE)**

(54) Kernresonanz-Spektroskopieverfahren.

(57) Die Erfindung betrifft ein volumenselektives
KernresonanzSpektroskopieverfahren. Die Volumenselektion erfolgt dabei nach der Anregung durch drei
schichtselektive 180°-Hochfrequenzimpulse, die die
Kernmagnetisierung in drei zuein5ander senkrechten
Schichten anregen. Der Abstand der drei selektiven
180°-Hochfrequenzimpulse kann so klein wie möglich gewählt werden.

Fig.3

Fig.4a

Fig.4b

Fig.4c

Fig.4d

EP 0 302 550 A2

## Kernresonanz-Spektroskopieverfahren

Die Erfindung betrifft ein Kernresonanz-Spektroskopieverfahren, bei dem auf einen Untersuchungsbereich eine Vielzahl von Sequenzen einwirkt, von denen jede wenigstens zwei Hochfrequenzimpulse umfaßt, wobei von Sequenz zu Sequenz der Abstand zwischen den Hochfrequenzimpulsen oder ihre Phase oder ihre Amplitude verändert wird.

Ein solches Verfahren ist u.a. aus J. Chem. Phys., Vol. 64, No. 10, 15 May 1976, Seiten 4226 bis 4227 bekannt. Jede Sequenz besteht dabei aus einem 90°- und einem 180°-Hochfrequenzimpuls, deren Abstand von Sequenz zu Sequenz geändert wird. Aus den im Anschluß an die 180°-Hochfrequenzimpulse auftretenden Echosignalen wird ein zweidimensionales Fourier-Spektrum bestimmt, wobei für die eine Frequenzachse der zeitliche Verlauf der Signale und für die andere Frequenzachse der zeitliche Abstand die Transformationsparameter sind.

Darüber hinaus sind Spektroskopieverfahren bekannt, bei denen die Sequenzen anders aufgebaut sind und/oder bei denen von Sequenz zu Sequenz anstatt des zeitlichen Abstandes von Hochfrequenzimpulsen deren Amplitude bzw. Phasenlage variiert wird. Auch bei diesen Verfahren kann durch eine zweidimensionale Fourier-Transformation ein zweidimensionales Spektrum erhalten werden.

Andererseits lassen sich mit Sequenzen der eingangs genannten Art auch sogenannte multiple-quantum-Experimente durchführen, bei denen durch die Hochfrequenzimpulse höhere Quantenkohärenzen angeregt werden.

In der Medizin besteht das Bedürfnis nach einer ortsaufgelösten Spektroskopie (Topical Magnetic Resonance), bei der nur ein eng umgrenzter Untersuchungsbereich, der beispielsweise ein intaktes Organ sein kann, einer spektroskopischen Analyse unterzogen wird. Es ist zu diesem Zweck bekannt (J. Mag. Reson. 56, Seiten 350 bis 354 (1984)), vor der spektroskopischen Anregung zunächst das anzuregende Volumen zu selektieren, indem in dem interessierenden Bereich die Kernmagnetisierung beibehalten wird, während sie außerhalb dieses Bereichs um 90° gekippt und anschließend dephasiert wird, so daß sie keinen Signalbeitrag mehr liefern kann. Die Definition des zu selektierenden Bereichs erfolgt dadurch, daß drei zueinander senkrechte Schichten angeregt werden, wobei jede Schicht in Anwesenheit eines magnetischen Gradientenfeldes einen selektiven 45°-Impuls, einen 90°-Breitbandimpuls und einen weiteren 45°-Hochfrequenzimpuls umfaßt. Erst im Anschluß daran erfolgt die spektroskopische Anregung durch einen einzelnen Hochfrequenzimpuls.

Dieses bekannte Verfahren zur Volumenselektion beeinflußt aber die nachfolgende spektroskopische Anregung, so daß es für zweidimensionale Spektroskopie, insbesondere aber für multiple-quantum-Experimente, ungeeignet ist.

Aufgabe der vorliegenden Erfindung ist es, ein für die zweidimensionale Spektroskopie bzw. für multiple-quantum-Experimente geeignetes Verfahren so auszugestalten, daß eine ortsaufgelöste (zweidimensionale) Spektroskopie möglich wird.

Diese Aufgabe wird erfindungsgemäß dadurch gelöst, daß am Ende einer jeden Sequenz drei 180°-Hochfrequenzimpulse erzeugt werden und daß während jedes dieser Hochfrequenzimpulse ein magnetisches Gradientenfeld mit einem in jeweils einer von drei zueinander senkrechten Richtungen verlaufenden Gradienten wirksam ist.

Bei der Erfindung erfolgt die Volumenselektion also im Anschluß an die spektroskopische Anregung durch drei schichtselektive 180°-Hochfrequenzimpulse, die die Kernmagnetisierung in drei zueinander senkrechten Schichten beeinflussen. In dem Schnittbereich dieser drei Schichten wirken die drei 180°-Hochfrequenzimpulse wie ein einziger 180°-Hochfrequenzimpuls, der die Kernmagnetisierung in dem angeregten Bereich refokussiert, ohne im übrigen die Spin-Spin-Wechselwirkungen und die Quantenkohärenzen zu beeinflussen. Dabei werden vorzugsweise die kernresonanzsignale ausgewertet, die um den Zeitpunkt herum auftreten, an dem die Kernmagnetisierung refokussiert ist. Ein weiterer Vorteil ist, daß der Abstand zwischen den Hochfrequenzimpulsen unabhängig von deren Abstand zu dem bzw. den voraufgehenden Impulsen der Sequenz gewählt werden kann. Wenn der letzte der nicht selektiven, der spektroskopischen Anregung dienenden Hochfrequenzimpulse ein 180°-Hochfrequenzimpuls ist, kann er entfallen. Seine Wirkung im Hinblick auf das selektierte Volumen wird durch diejenige der drei schichtselektiven 180°-Hochfrequenzimpulse ersetzt.

Es sei an dieser Stelle erwähnt, daß aus dem "Book of Abstracts" der S.M.R.M., Vol. 3, 1986, Seiten 981 und 982 bereits ein volumenselektives Spektroskopieverfahren bekannt ist, bei dem auf einen binomialen 90°-Hochfrequenzimpuls drei schichtselektive 180°-Hochfrequenzimpulse folgen. Es handelt sich hierbei um eine Carr-Purcel-Sequenz, bei der die drei auf den 90°-Impuls folgenden 180°-Impulse schichtselektiv gestaltet sind. Der Abstand zwischen zwei benachbarten 180°-Hochfrequenzimpulsen muß dabei doppelt so groß sein, wie der Abstand zwischen dem ersten 180°-Impuls und dem binomialen 90°-Hochfrequenzimpuls. Weiterhin ist dabei von Nachteil, daß das Verfahren kein zweidimensionales Spektrum liefern kann.

Die Erfindung wird nachstehend anhand der Zeichnung näher erläutert. Es zeigen:

Fig. 1 ein Gerät für medizinische Kernresonanzuntersuchungen, mit dem das erfindungsgemäße Verfahren durchführbar ist,

Fig. 2 ein Blockschaltbild eines solchen Gerätes,

Fig. 3 die zeitliche Lage der Signale für die Spektroskopie und für die Volumenselektion sowie des Kernsonanzsignals, und

Fig. 4 den zeitlichen Verlauf der für die Volumenselektion erforderlichen Impulse.

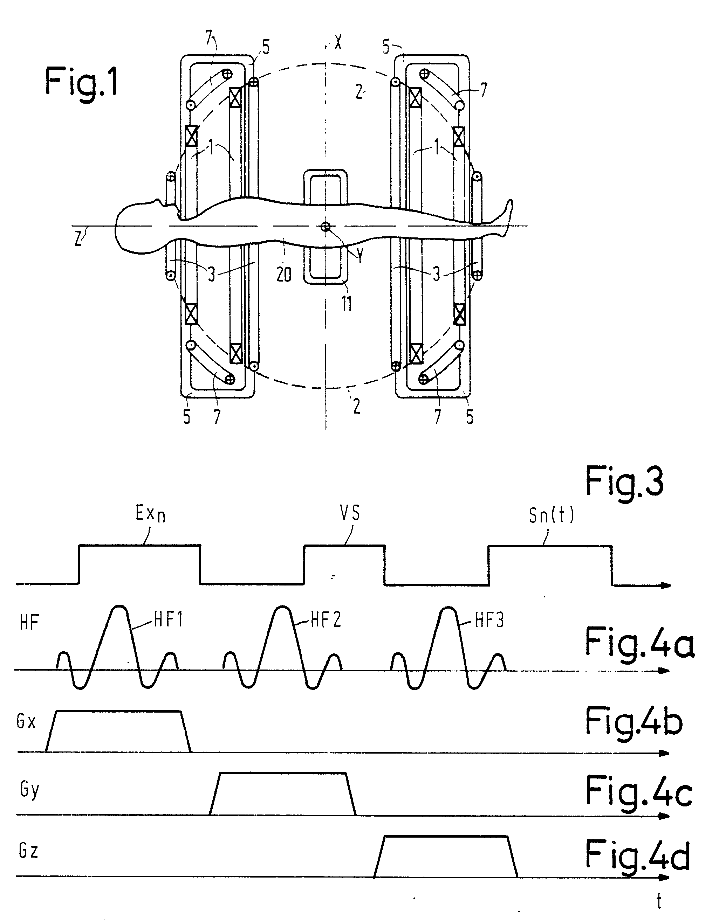

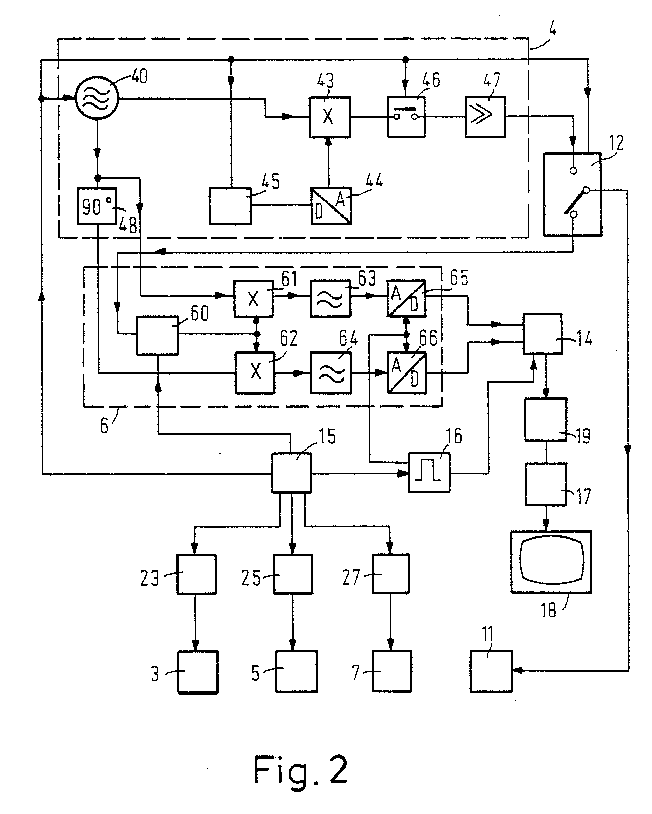

Das in Fig. 1 schematisch dargestellte Kernspin-Untersuchungsgerät enthält eine aus vier Spulen 1 bestehende Anordnung zur Erzeugung eines homogenen stationären Magnetfeldes, das in der Größenordnung von einigen Zehntel T bis einigen T liegen kann. Dieses Feld verläuft in z-Richtung eines kartesischen Koordinatensystems. Die zur z-Achse konzentrisch aneordneten Spulen 1 können auf einer Kugeloberfläche 2 angeordnet sein. Im Innern dieser Spulen befindet sich der zu untersuchende Patient 20.

Zur Erzeugung eines in z-Richtung verlaufenden und sich in dieser Richtung linear ändernden Magnetfeldes Gz sind vier Spulen 3 vorzugsweise auf der gleichen Kugeloberfläche angeordnet. Weiterhin sind vier Spulen 7 vorgesehen, die ein ebenfalls in z-Richtung verlaufendes magnetisches Gradientenfeld (d.h. ein Magnetfeld, dessen Stärke sich in einer Richtung linear ändert) Gx erzeugen, dessen Gradient jedoch in x-Richtung verläuft. Ein in z-Richtung verlaufendes magnetisches Gadientenfeld Gy mit einem Gradienten in y-Richtung wird von vier Spulen 5 erzeugt, die die gleiche Form haben können wie die Spulen 7, die jedoch diesen gegenüber um 90° versetzt angeordnet sind. Von diesen vier Spulen sind in Fig. 1 nur zwei dargestellt.

Da jede der drei Spulenanordnungen 3, 5 und 7 zur Erzeugung der magnetischen Gradientenfelder Gz, Gy und Gx symmetrisch zur Kugeloberfläche 2 angeordnet ist, ist die Feldstärke im Kugelzentrum, das gleichzeitig den Koordinatenursprung des erwähnten kartesischen xyz-Koordinatensystems bildet, nur durch das stationäre homogene Magnetfeld der Spulenanordnung 1 bestimmt. Weiterhin ist eine Hochfrequenzspule 11 symmetrisch zur Ebene z = 0 des Koordinatensystems angeordnet, die so ausgebildet ist, daß damit ein im wesentlichen homogenes und in x-Richtung, d.h. senkrecht zur Richtung des stationären homogenen Magnetfeldes verlaufendes hochfrequentes Magnetfeld erzeugt wird. Der Hochfrequenzspule wird während jedes Hochfrequenzimpulses ein hochfrequenter modulierter Strom von einem Hochfrequenzgenerator zugeführt. - Im Anschluß an drei Hochfrequenzimpulse dient die Hochfrequenzspule 11 zum Empfangen des im Untersuchungsbereich erzeugten Echosignals. Statt dessen kann aber auch eine gesonderte Hochfrequenz-Empfangsspule verwendet werden.

Fig. 2 zeigt ein vereinfachtes Blockschaltbild dieses Kernspin-Untersuchungsgerätes. Die Hochfrequenzspule 11 ist über eine Umschalteinrichtung 12 einerseits an einen Hochfrequenzgenerator 4 und andererseits an einen Hochfrequenzempfänger 6 angeschlossen.

Der Hochfrequenzgenerator 4 enthält einen in seiner Frequenz digital steuerbaren Hochfrequenzoszillator 40, der Schwingungen mit einer Frequenz gleich der Larmorfrequenz der anzuregenden Atomkerne bei der von den Spulen 1 erzeugten Feldstärke liefert. Die Larmorfrequenz f berechnet sich bekanntlich nach der Beziehung f = cB, wobei B die magnetische Induktion in dem stationären homogenen Magnetfeld darstellt und c das gyromagnetische Verhältnis, das beispielsweise für Protonen 42,56 MHz/T beträgt. Der Ausgang des Oszillators 40 ist mit einem Eingang einer Mischstufe 43 verbunden. Der Mischstufe 43 wird ein zweites Eingangssignal von einem Digital-Analog-Wandler 44 zugeführt, dessen Ausgang mit einem digitalen Speicher 45 verbunden ist. Aus dem Speicher wird - gesteuert durch eine Steuereinrichtung 15 - eine Folge von ein Hüllkurvensignal darstellenden digitalen Datenworten ausgelesen.

Die Mischstufe 43 verarbeitet die ihr zugeführten Eingangssignale so, daß an ihrem Ausgang die mit dem Hüllkurvensignal modulierte Trägerschwingung erscheint. Das Ausgangssignal der Mischstufe 43 wird über einen von der Steuereinrichtung 15 gesteuerten Schalter 46 einem Hochfrequenz-Leistungsverstärker 47 zugeführt, dessen Ausgang mit der Umschalteinrichtung 12 verbunden ist. Diese wird ebenfalls durch die Steuereinrichtung 15 gesteuert.

Der Empfänger 6 enthält einen Hochfrequenzverstärker 60, der mit der Umschalteinrichtung verbunden ist und dem das in der Hochfrequenzspule 11 induzierte Echosignal zugeführt wird, wobei die Umschalteinrichtung den entsprechenden Schaltzustand haben muß. Der Verstärker 60 besitzt einen von der Steuereinrichtung 15 gesteuerten Stummschalteingang, über den er gesperrt werden kann, so daß die Verstärkung praktisch Null ist. Der Ausgang des Verstärkers ist mit den ersten Eingängen zweier multiplikativer Mischstufen 61 und 62 verbunden, die jeweils ein dem Produkt ihrer Eingangssignale entsprechendes Ausgangssignal liefern. Den zweiten Eingängen der Mischstufen 61 und 62 wird ein Signal mit der Frequenz des Oszillators 40 zugeführt, wobei zwischen den Signalen an den beiden Eingängen eine Phasenverschiebung von 90° besteht. Diese Phasenverschiebung wird mit Hilfe eines 90° Phasendreh gliedes 48 erzeugt, dessen Ausgang mit dem Eingang der Mischstufe 62 und dessen Eingang mit dem Eingang der Mischstufe 61 und mit dem Ausgang des Oszillators 40 verbunden ist.

Die Ausgangssignale der Mischstufe 61 und 62 werden über Tiefpässe 63 und 64, die die vom Oszillator 40 gelieferte Frequenz sowie alle darüberliegenden Frequenzen unterdrücken und niederfrequente Anteile durchlassen, je einem Analog-Digital-Wandler 65 bzw. 66 zugeführt. Dieser setzt die analogen Signale der einen Quadratur-Demodulator bildenden Schaltung 61...64 in digitale Datenworte um, die einem Speicher 14 zugeführt werden. Die Analog-Digital-Wandler 65 und 66 sowie der Speicher 14 erhalten ihre Taktimpulse von einem Taktimpulsgenerator 16, der über eine Steuerleitung von der Steuereinrichtung 15 blockiert bzw. freigegeben werden kann, so daß nur in einem durch die Steuereinrichtung 15 definierten Meßintervall die von der Hochfrequenzspule 11 gelieferten, in den Niederfrequenzbereich transponierten Signale in eine Folge digitaler Datenworte umgesetzt und in dem Speicher 14 gespeichert werden können.

Die drei Spulenanordnungen 3, 5 und 7 werden von Stromgeneratoren 23, 25 und 27 jeweils mit einem Strom versorgt, dessen zeitlicher Verlauf durch die Steuereinheit 15 steuerbar ist. Die im Speicher 14 gespeicherten Datenworte bzw. Abtastwerte werden einem Rechner zugeführt, der daraus durch eine zweidimensionale diskrete Fourier-Transformation ein zweidimensionales Spektrum der Kernmagnetisierung ermittelt und an einer geeigneten Wiedergabeeinheit, z.B. einem Monitor 18, ausgibt.

Wie sich aus Fig. 3 ergibt, enthält jede Sequenz eine erste Teilsequenz Exn, die mindestens zwei Hochfrequenzimpulse umfaßt, deren Abstand voneinander oder deren Phasenlage oder Amplitude von Sequenz zu Sequenz geändert wird. Ein Beispiel einer derartigen spektroskopischen Teilsequenz ist in der eingangs erwähnten Literaturstelle J. Chem. Phys., Vol. 64, No. 10, 15. May 1976, Seiten 4426 und 4427 beschrieben. Diese Teilsequenz besteht aus einem 90°- und einem 180°-Hochfrequenzimpuls, wobei wie eingangs erwähnt der 180°-Hochfrequenzimpuls auch entfallen kann. Andere Beispiele für solche Teilsequenzen und von Teilsequenzen, die sich für multiplequantum-Experimente eignen, sind in dem Buch von N. Chandrakumar und S. Subramanian "Modern Techniques in High-Resolution FT-NMR", Springerverlag, New York (1987) beschrieben.

In dieser Phase wird lediglich der Hochfrequenzspule 11 Energie zugeführt; die Stromgeneratoren 23...27 sind abgeschaltet, so daß keine magnetischen Gradientenfelder erzeugt werden können.

Im Anschluß an die Teilsequenz Exn folgt eine Teilsequenz VS, die der Volumenselektion dient. In dieser weiter unten näher erläuterten Phase wird sowohl der Hochfrequenzspule 11 als auch den Gradientenspulen 3, 5 und 7 zeitweise Energie zugeführt. Durch die Teilsequenz VS wird einerseits eine Refokussierung der Kernmagnetisierung und andererseits eine Volumenselektion bewirkt. - Im Anschluß daran folgt ein Zeitintervall, in dem das Echosignal Sn(t) abgetastet wird. In diesem Intervall befindet sich (im Gegensatz zu den beiden vorherigen Zeitintervallen) der Umschalter 12 in der in Fig. 2 dargestellten Stellung; außerdem wird der Taktimpulsgenerator 16 von der Steuereinrichtung 15 freigegeben, so daß die von der Hochfre quenzspule empfangenen, in den Niederfrequenzbereich transponierten Signale in eine Folge digitaler Datenworte umgesetzt und in dem Speicher 14 gespeichert werden können.

Fig. 4a bis 4d zeigt den zeitlichen Verlauf der zweiten Teilsequenzen VS. Diese zweite Teilsequenz umfaßt drei - vorzugsweise in gleichem Abstand - aufeinanderfolgende 180°-Hochfrequenzimpulse HF1, HF2, HF3. Während des ersten Hochfrequenzimpulses ist der Stromgenerator 27 eingeschaltet, der einen Strom durch die Gradientenspulen 7 liefert, wodurch ein magnetisches Gradientenfeld Gx mit einem in x-Richtung verlaufenden Gradienten erzeugt wird. Dadurch wird bewirkt, daß die Kernmagnetisierung in einer zur x-Achse senkrechten Schicht, deren Dicke von der Bandbreite des ersten 180°-Hochfrequenzimpulses HF1 und von der Größe des Gradienten und deren Lage von der Mittenfrequenz des Impulses HF1 abhängt, invertiert wird. Außerhalb der Schicht wird die Kernmagnetisierung durch das magnetische Gradientenfeld Gx dephasiert.

Während des zweiten 180°-Hochfrequenzimpulses HF2 ist der Stromgenerator 25 eingeschaltet, der einen Strom durch die Gradientenspulen 5 liefert. Dadurch wird ein magnetisches Gradientenfeld Gy mit einem in y-Richtung verlaufenden Gradienten erzeugt. In Verbindung mit dem zweiten Hochfrequenzimpuls HF2 bewirkt dieses Gradientenfeld, daß die Kernmagnetisierung in einer zur y-Achse senkrechten Schicht dephasiert ist. Die Lage dieser Schicht auf der y-Achse ist durch die Frequenz des Impulses HF2 bestimmt und ihre Dicke durch die Bandbreite des Impulses HF2 und die Größe des Gradienten. Nach dem zweiten Hochfrequenzimpuls ist die Kernmagnetisierung daher überall außerhalb des Schnittbereiches der beiden Schichten dephasiert; nur im Schnittbereich der beiden Schichten wird eine erneute Invertierung erreicht, so daß sich die Kernmagnetisierung in dem gleichen Zustand befindet wie vor dem ersten Hochfrequenzimpuls HF1.

Während des dritten 180°-Hochfrequenzimpulses HF3 ist der Stromgenerator 23 eingeschaltet, so daß ein Strom die Gradientenspulen 3 durchfließt, wodurch ein magnetisches Gradientenfeld Gz mit in z-Richtung verlaufendem Gradienten erzeugt wird. Dadurch wird die Kernmagnetisierung in einer zur z-Achse senkrechten Schicht invertiert und außerhalb der Schicht dephasiert. Lage und Dicke der Schicht werden dabei durch die Frequenz bzw. die Bandbreite des Hochfrequenzimpulses und die Größe des Gradienten bestimmt. Da vor dem dritten Hochfrequenzimpuls HF3 lediglich die Kernmagnetisierung in dem erwähnten Schnittbereich noch nicht dephasiert ist, ist nach dem dritten Hochfrequenzimpuls die Kernmagnetisierung in dem Volumenelement invertiert, in dem sich die drei erwähnten Schichten schneiden; überall außerhalb dieses Volumenelementes ist die Kernmagnetisierung durch die magnetischen Gradientenfelder dephasiert. Um die Dephasierung außerhalb des selektierten Volumens zu verstärken, ist es von Vorteil, das magnetische Gradientenfeld Gx, Gy bzw. Gz schon eine Zeitspanne vor dem Hochfrequenzimpuls HF1, HF2 bzw. HF3 einzuschalten und erst eine entsprechende Zeitspanne danach auszuschalten, wobei der Gradient vorzugsweise größer ist als während des jeweiligen Hochfrequenzimpulses. Dabei muß das zeitliche Integral über das magnetische Gradientenfeld vom Einschalten dieses Feldes bis zur Mitte des Hochfrequenzimpulses genauso groß sein wie von der Mitte des Impulses bis zum Ausschalten des Feldes. Diese "Spoiler" des magnetischen Gradientenfeldes haben keinen Enfluß auf die Abmessungen des selektierten Volumens, da sie außerhalb der Hochfrequenzimpulse wirken. Darüber hinaus dephasieren sie bei multiplequantum-Experimenten Spinkohärenzen, die ihren Quantenzustand ändern.

Die drei Hochfrequenzimpulse HF1...HF3 wirken also in Verbindung mit den magnetischen Gradientenfeldern Gx...Gz in bezug auf das Volumenelement wie ein einziger 180°-Impuls, dessen zeitliche Lage bei gleichem Abstand zwischen den Hochfrequenzimpulsen derjenigen des zweiten 180°-Hochfrequenzimpulses entspricht, der die Kernmagnetisierung in diesem Volumenelement wieder refokussiert. Das in geeignetem zeitlichen Abstand nach den drei Hochfrequenzimpulsen HF1...HF3, d.h. um den Zeitpunkt der Refokussierung herum, empfangene Echosignal ist aufgrund der geschilderten Zusammenhänge somit nur durch die stoffliche Zusammensetzung dieses Volumenelementes bestimmt; im übrigen wird aber der zeitliche Verlauf des Echosignals durch die Volumenselektion nicht beeinflußt.

Im Gegensatz zu einer Carr-Purcel-Sequenz kommt es bei der Erfindung nicht darauf an, daß der zeitliche Abstand zwischen den einzelnen Hochfrequenzimpulsen HF1...HF3 doppelt so groß ist wie der zeitliche Abstand des ersten Hochfrequenzimpulses von dem (letzten) Hochfrequenzimpuls der Teilsequenz Exn. Vielmehr ist es in der Regel von Vorteil, wenn der Abstand zwischen den Hochfrequenzimpulsen kleiner ist, vorzugsweise klein im Vergleich zum Abstand zu dem letzten Hochfrequenzimpuls aus der Teilsequenz Exn.. Dies führt bei einem vorgegebenen Abtastintervall - symmetrisch zum Refokussierungszeitpunkt für das Echosignal (Sn(t))zu kürzeren Echozeiten und damit zu einem verbesserten Signal-Rauschverhältnis. Andererseits wird - bei vorgegebener Echozeit - der zeitliche Abstand zwischen dem mit dem Hochfrequenzimpuls HF3 verknüpften Gradientenfeld und dem Echosignal sn(t) vergrößert, was zu einer Verringerung der durch dieses Gradientenfeld hervorgerufenen Wirbelstromeffekte führt. Außerdem können Spin-Echo-Signale zwischen den drei 180°-Hochfrequenzimpulsen HF1...HF3 nicht auftreten.

## Ansprüche

Kernresonanz-Spektroskopieverfahren, bei dem auf einen Untersuchungsbereich eine Vielzahl von Sequenzen einwirkt, von denen jede wenigstens zwei Hochfrequenzimpulse umfaßt, wobei von Sequenz zu Sequenz der Abstand zwischen den Hochfrequenzimpulsen oder ihre Phase oder ihre Amplitude verändert wird,

dadurch gekennzeichnet, daß am Ende einer jeden Sequenz drei 180°-Hochfrequenzimpulse erzeugt werden und daß während jedes dieser Hochfrequenzimpulse ein magnetisches Gradientenfeld mit einem in jeweils einer von drei zueinander senkrechten Richtungen verlaufenden Gradienten wirksam ist.

Fig.1

Fig.3

Fig.4a

Fig.4b

Fig.4c

Fig.4d

Fig. 2